# EUROPEAN PATENT APPLICATION

(11) **EP 2 477 001 A2**
(43) Date of publication of application: **18.07.2012**
(21) Application number: 12150843.6
(22) Date of filing: 11.01.2012
(51) Int. Cl.: G01D 4/00, G01R 19/25, G06F 1/26, H04L 29/06, G06Q 50/06

(54) **Systems, methods, and apparatus for powering an AMI communication board**

(30) Priority: 12.01.2011 US 201113005284
(71) Applicant: General Electric Company, Schenectady, NY 12345 (US)
(72) Inventor: Hanley, James Patrick, Decatur, GA 30033 (US)
(74) Representative: Cleary, Fidelma

(57) **Abstract**

Systems (200), methods (300), and apparatus for powering an AMI communication board (210) are provided. A smart power meter (205) may include both a meter metrology component (225) configured to monitor an amount of energy supplied via a power line and a Universal Serial Bus (USB) device controller (215) configured to interface with a USB connection (250). An AMI board (210) configured to facilitate communication over an AMI network may include a USB host controller (220) configured to communicate with the USB device controller (215). The USB host controller (220) and the AMI board (210) may be powered by the USB device controller (215) via the USB connection (250).

## Description

### FIELD OF THE INVENTION

Embodiments of the invention relate generally to utility meters, and more specifically to systems, methods, and apparatus for powering an Automated Metering Infrastructure ("AMI") communication board connected to a utility meter.

### BACKGROUND OF THE INVENTION

Utility meters, such as electrical meters, are typically utilized at residences and businesses to monitor the provision of one or more utility services. Recently, a wide variety of different types of smart meters and advanced meters have been developed to facilitate the collection of additional consumption data for provision to a local utility or other collection system. Smart meters are utilized for a wide variety of purposes, including billing purposes, outage detection, voltage level detection, volt-ampere reactive loss detection, detection of aggregated load on transformers, and submetering of appliance usage.

Typically, an Advanced Metering Infrastructure (AMI) communication board is provided in association with a smart meter. The AMI board facilitates the communication of measurements data onto an AMI network. In order to facilitate this communication, the AMI board must be provided with a suitable power signal. One conventional method for powering the AMI board is to connect the AMI board directly to the power line monitored by the smart meter; however, drawing power directly from the line requires additional power isolation and presents a safety concern for field technicians. Another conventional method for powering the AMI board involves embedding the AMI board into the smart meter in order to share a common power source. However, embedding the AMI board into the smart meter ties the meter to a specific AMI vendor, thereby limiting meter flexibility. Additionally, in the event that improved communication technologies become available, it is often necessary to replace the entire smart meter to take advantage of the new technology.

Accordingly, improved systems, methods, and apparatus for powering an AMI communication board are desirable.

### BRIEF DESCRIPTION OF THE INVENTION

According to a first aspect, the invention resides in a power meter including a metrology component and a Universal Serial Bus (USB) controller. The metrology component may be configured to monitor an amount of energy supplied via a power line associated with the power meter. The USB device controller may be configured to (i) interface with an Advanced Metering Infrastructure (AMI) board via a USB connection and (ii) provide power to the AMI board via the USB connection.

According to another aspect, the invention resides in a system for powering an AMI communication board including a smart power meter as described above and an AMI board. The AMI board may be configured to facilitate communication over an AMI network, and the AMI board may include a USB host controller configured to communicate with the USB device controller. Additionally, the USB host controller and the AMI board are powered by the USB device controller via the USB connection.

According to yet another aspect, the invention resides in a method for powering an AMI communication board associated with a utility meter. A power meter may be provided, and the power meter may include (i) a meter metrology component configured to monitor an amount of energy supplied via a power line and (ii) a Universal Serial Bus (USB) device controller configured to interface with a USB connection. The power meter may be connected, via the USB connection, to an Advanced Metering Infrastructure (AMI) board configured to facilitate communication over an AMI network. The AMI board may include a USB host controller. The USB device controller may power, via the USB connection, the USB host controller and the AMI board.

Additional systems, methods, apparatus, features, and aspects are realized through the techniques of various embodiments of the invention. Other embodiments and aspects of the invention are described in detail herein and are considered a part of the claimed invention. Other embodiments and aspects can be understood with reference to the description and the drawings.

### BRIEF DESCRIPTION OF THE DRAWINGS

Embodiments of the present invention will now be described, by way of example only, with reference to the accompanying drawings in which:
Having thus described the invention in general terms, reference will now be made to the accompanying drawings, which are not necessarily drawn to scale, and wherein:
   FIG. 1 is a block diagram of a conventional system for powering an AMI communication board associated with a utility meter.
   FIG. 2 is a block diagram of one example system that facilitates powering an AMI communication board associated with a utility meter, according to an illustrative embodiment of the invention.
   FIG. 3 is a flow diagram of an example method for powering an AMI communication board associated with a utility meter, according to an illustrative embodiment of the invention.

### DETAILED DESCRIPTION OF THE INVENTION

Illustrative embodiments of the invention now will be described more fully hereinafter with reference to the accompanying drawings, in which some, but not all embodiments of the invention are shown. Indeed, the invention may be embodied in many different forms and should not be construed as limited to the embodiments set forth herein; rather, these embodiments are provided so that this disclosure will satisfy applicable legal requirements. Like numbers refer to like elements throughout.

Disclosed are systems, methods, and apparatus for powering Advanced Metering Infrastructure (AMI) communication boards associated with utility meters. According to one example embodiment a smart power meter and an AMI board may be provided. The smart power meter may include a Universal Serial Bus (USB) device controller configured to interface with a USB connection. The AMI board, which may be configured to facilitate communication over an AMI network (e.g., communication of data collected by the smart power meter), may include a USB host controller configured to communicate with the USB device controller. The USB host controller and the AMI board may be powered by the USB device controller via the USB connection.

For example, when a connection is established between the USB device controller and the USB host controller, a relatively low voltage power signal, such as signal having a voltage between approximately 3.3 volts and approximately 5 volts, may be output by the USB device controller for receipt by the USB host controller. The USB host controller may be initially powered by the low voltage power, and the USB host controller may conduct a handshaking process with the USB device controller. Additionally, the USB host controller may communicate one or more power configuration parameters to the USB device controller. The USB device controller may utilize the one or more power configuration parameters to modify or adjust an amount of power supplied to the USB host controller via the USB connection. In this regard, the USB host controller and the AMI board may be powered via the USB connection.

Various embodiments of the invention may include one or more special purpose computers, systems, and/or particular machines that facilitate the provision or supply of power to an AMI communication board. A special purpose computer or particular machine may include a wide variety of different software modules as desired in various embodiments. As explained in greater detail below, in certain embodiments, these various software components may be utilized to initialize a connection between a utility meter and an AMI communication board and/or to provide an appropriate power signal to the AMI communication board.

Certain embodiments of the invention described herein may have the technical effect of supplying an appropriate power signal from a utility meter to an AMI communication board associated with the utility meter. For example, a Universal Serial Bus (USB) device controller is integrated into a smart utility meter, and the USB device controller is connected to a USB host controller associated with the AMI communication board. The USB device controller has the technical effect of establishing communication with the USB host controller and providing a suitable power signal to the USB host controller for powering the AMI communication board.

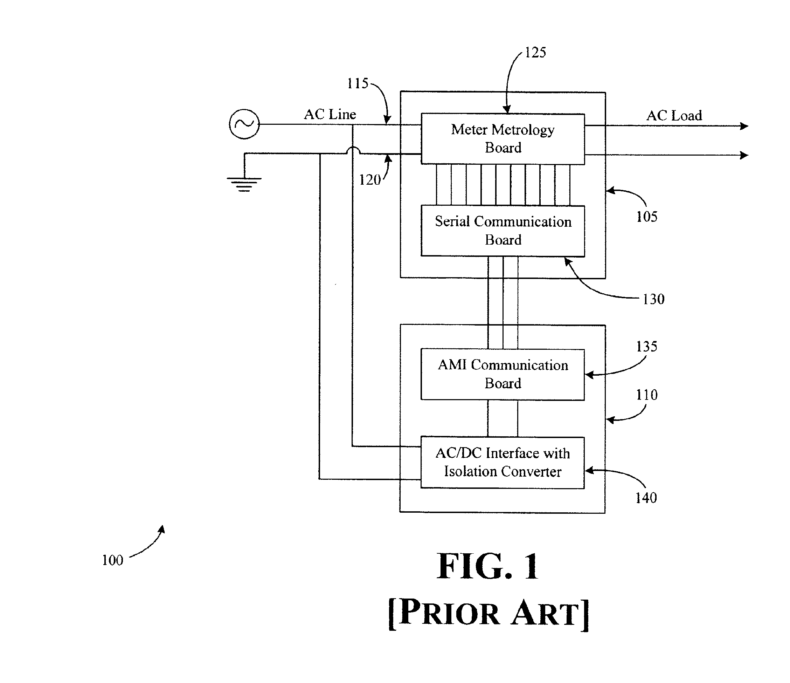

FIG. 1 is a block diagram of a conventional system 100 for powering an AMI communication board associated with a utility meter. With reference to FIG. 1, a utility meter 105 and an AMI communication component 110 are provided. The utility meter 105 is connected to a power line associated with a power system or power distribution network. As shown, an alternating current (AC) power connection 115 and a ground connection 120 are connected to a line side of the utility meter 105. An AC power signal is received on the line side and passed through the utility meter to a load side. On the load side, the AC power signal is provided to a household, structure or other electrical load.

Additionally, the utility meter 105 includes a meter metrology board 125 or other measurement component that facilitates monitoring of the AC power signal. The metrology board 125 measures an amount of power that is supplied to a load side of the utility meter 105. Measurements data is provided by the metrology board 125 to a serial communication board 130 via a suitable interface, such as a ten (10) pin interface. The serial communication board 130 facilitates communication with an AMI communication board 135 incorporated into the AMI communication component 110. A serial connection is formed between the serial communication board 130 and the AMI communication board 135, and measurements data is communicated by the utility meter 105 to the AMI communication component 110 via the serial connection. Once received, the AMI communication component 110 facilitates the communication of the measurements data over an AMI network.

With continued reference to FIG. 1, the AMI communication component 110 includes a power interface component 140 configured to supply power to the AMI communication board 135. The power interface component 140 pulls power from the power line or power connections, and the power interface component 140 converts or rectifies the power into a direct current (DC) power signal that is supplied to the AMI communication board 135. In this regard, the power interface component 140 serves as an isolated power supply for the AMI communication board 135. However, the use of the power interface component 140 increases the overall cost of the utility meter and the AMI communication component 110. Additionally, the direct connection of the AMI communication component 110 to the power line presents a safety concern for field technicians servicing the utility meter.

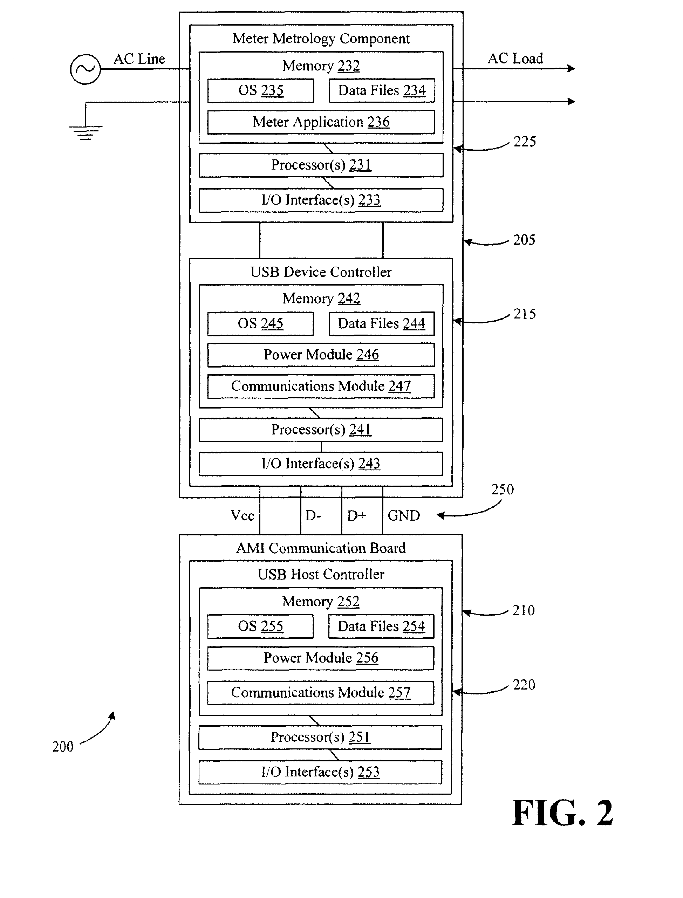

FIG. 2 is a block diagram of one example system 200 that facilitates powering an AMI communication board associated with a utility meter, according to an illustrative embodiment of the invention. The system 200 illustrated in FIG. 2 may include a utility meter 205 and an AMI communication board 210 associated with the utility meter 205. According to an aspect of the invention, the AMI communication board 210 may be directly powered by the utility meter 205. For example, the utility meter 205 may include a suitable USB device controller 215 configured to provide power to a USB host controller 220 associated with the AMI communication board 210.

With reference to FIG. 2, the utility meter 205 may be any suitable utility meter that may be connected to a power line or power distribution system. For example, the utility meter 205 may be a suitable electrical meter or power meter that is connected to a single phase or a three-phase electrical power system. As such, the utility meter 205 may be configured to measure an amount of electrical energy (e.g., kilowatt hours, etc.) or electrical power that is supplied to an associated residence, business, or machine. In certain embodiments, the utility meter 205 may be a smart meter or an advanced meter configured to identify consumption in relatively greater detail than a conventional meter. For example, a smart utility meter 205 may facilitate real-time or near real-time readings, power outage notification, and/or power quality monitoring. Additionally, as desired, a smart utility meter 205 may make use of an associated AMI communication board 210 to communicate measurements data, calculations, and/or other information to one or more recipients, such as a local utility or smart meter data processing system via one or more suitable AMI networks. The communicated data and/or information may then be utilized for various monitoring and/or billing purposes.

The utility meter 205 may include any number of suitable processor-driven devices and/or processing components that facilitate the monitoring of an electrical power supply and/or the output of measurements data for communication. Additionally, the utility meter 205 may include any number of suitable processor-driven devices and/or processing components that facilitate communication with an AMI communication board 210 and/or the provision of power to the AMI communication board. As shown in FIG. 2, the utility meter 205 may include a meter metrology component 225 and the previously mentioned USB device controller 215. The meter metrology component 225, which may be referred to as the metrology component 225, may be a suitable processor-driven device or processing component that is configured to monitor and/or measure an amount of electrical energy or electrical energy supplied on a load side of the utility meter 205. Examples of suitable processing devices that may be utilized as a metrology component 225 include, but are not limited to, application specific-circuits, microcontrollers, minicomputers, other computing devices, and the like. As such the metrology component 225 may include any number of processors 231 that facilitate the execution of computer-readable instructions to control the operations of the utility meter 205 and/or the metrology component 225. By executing computer-readable instructions, the metrology component 225 may form a special purpose computer or particular machine that facilitates monitoring of an electrical power supply or power signal that is supplied to a household or other load associated with the utility meter 205.

In addition to one or more processors 231, the metrology component 225 may include one or more memory devices 232 and/or one or more input/output (I/O) interfaces 233. The one or more memory devices 232 or memories may include any number of suitable memory devices, for example, caches, read-only memory devices, random access memory devices, magnetic storage devices, etc. The one or more memory devices 232 may store data, executable instructions, and/or various program modules utilized by the metrology component 225, such as data files 234, an operating system (OS) 235, and/or a meter application 236. The data files 234 may include stored data associated with the operation of the metrology component 225, stored data associated with measurements and/or readings taken by the metrology component 225, stored data associated with calculations made by the metrology component 225, and/or stored data associated with the USB device controller 215.

The OS 235 may be a suitable software application that is executed by the one or more processors 231 to control the general operation of the metrology component 225 and/or the utility meter 205. Additionally, the OS 235 may facilitate the execution of additional software applications, such as the meter application 236. The meter application 236 may be a suitable software application that facilitates the monitoring of a power signal associated with the utility meter 205 and/or the monitoring of an amount of power supplied to a household or other load associated with the utility meter 205. In operation, the meter application 236 may receive measurements data from any number of suitable sensors and/or monitoring devices associated with the utility meter 205 and/or the metrology component 225, such as one or more voltage sensors, current sensors, timers, and/or other monitoring devices. As desired, the meter application 236 may utilize received measurements data to perform any number of calculations and/or analyses associated with the utility meter 205. Additionally, the meter application 236 may generate any number of messages, such as messages associated with meter usage, power outages, etc., to be communicated via an AMI network. Once generated, a message may be provided by the meter application 236 to the USB device controller 215 via a suitable I/O interface between the metrology component 225 and the USB device controller 215, such as a suitable ten (10) pin interface. In this regard, the USB device controller 215 may receive data and/or messages that are provided to the AMI communication board 210 for communication via the AMI network.

The one or more I/O interfaces 233 may facilitate connection of the metrology component 225 to any number of suitable input/output devices and/or device controllers. For example, the I/O interfaces 233 may include a suitable interface that facilitates connection of the metrology component 225 to the USB device controller 215. A wide variety of suitable interfaces may be utilized as desired in various embodiments of the invention, such as a ten (10) pin interface.

With continued reference to FIG. 2, the utility meter 205 may include a suitable USB device controller 215. Similar to the metrology component 225, the USB device controller 215 may be a suitable processor-driven device or processing component that is configured to facilitate communication with the USB host controller 220 associated with the AMI communication board 210 and to provide power to the AMI communication board 210 via a suitable USB connection. Examples of suitable processing devices that may be utilized as a USB device controller 215 include, but are not limited to, application-specific circuits, microcontrollers, minicomputers, other computing devices, and the like. As such, the USB device controller 215 may include any number of processors 241 that facilitate the execution of computer-readable instructions to control the operations of the USB device controller 215. By executing computer-readable instructions, the USB device controller 215 may form a special purpose computer or particular machine that facilitates powering of the AMI communication board 210 and/or communication between the utility meter 205 and the AMI communication board 210. Additionally, although the metrology component 225 and the USB device controller 215 are illustrated as separate components, as desired, the metrology component 225 and the USB device controller 215 may be combined into a single device or component.

In addition to one or more processors 241, the USB device controller 215 may include one or more memory devices 242 and/or one or more input/output (I/O) interfaces 243. The one or more memory devices 242 or memories may include any number of suitable memory devices, for example, caches, read-only memory devices, random access memory devices, magnetic storage devices, etc. The one or more memory devices 242 may store data, executable instructions, and/or various program modules utilized by the USB device controller 215, such as data files 244, an operating system (OS) 245, a power module 246 and/or a communications module 247. The data files 244 may include, for example, stored data associated with the operation of the USB device controller 215, stored data associated with the USB host controller 220, and/or stored data associated with power requirements of the USB host controller 220.

The OS 245 may be a suitable software application that is executed by the one or more processors 241 to control the general operation of the USB device controller 215. Additionally, the OS 245 may facilitate the execution of additional software applications, such as the power module 246 and/or the communications module 247. The power module 246 may be a suitable software application that facilitates the provision of power to the USB host controller 220 and/or the AMI communication board 210. According to an aspect of the invention, the power may be supplied via a suitable USB connection 250, such as a USB cable, that facilitates connection of the USB device controller 215 to the USB host controller 210.

In operation, the power module 246 may direct the USB device controller 215 to output a relatively low voltage power signal onto the USB connection 250. For example, a voltage signal of approximately 3.3 volts to approximately five (5) volts may be output onto a suitable voltage line associated with the USB connection 250. Additionally, as desired, a suitable ground line associated with the USB connection 250 may be tied to ground. In certain embodiments, the low voltage power signal may be output based upon a powering up or resetting of the USB device controller 215. In other embodiments, the low voltage power signal may be output based upon a detection of a connected USB cable. In yet other embodiments, the low voltage power signal may be output based upon a detection of the USB host controller 220. For example, a suitable USB hub device may be situated between the USB device controller 215 and the USB host controller 220. The hub device may detect or identify a connection of the USB host controller 220 and communicate information associated with the detection to the USB device controller 215.

As a result of outputting the relatively low voltage signal, the USB host controller 220 may be initially powered by the USB device controller 215. Once the USB host controller 220 receives initial power, the USB host controller 220 may perform a handshaking process to establish communications between the USB host controller 220 and the USB device controller 215. A wide variety of information may be passed between the USB device controller 215 and the USB host controller 220 during the handshaking process, such as a device identifier and/or configuration information associated with the USB device controller 215.

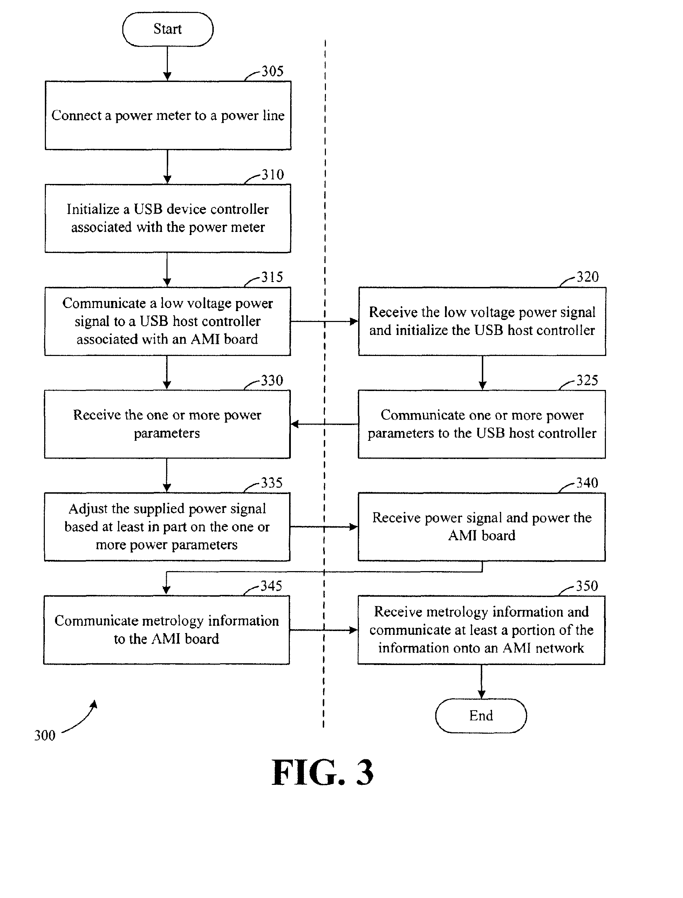

Additionally, in accordance with an aspect of the invention, the USB host controller 220 may communicate one or more power parameters, such as power configuration parameters, to the USB device controller 215. These one or more power parameters may specify the power requirements of the USB host controller 220 and/or the AMI communication board 210. A wide variety of different power parameters may be communicated to the power module 246 of the USB device controller 215, such as power amplitude requirements, voltage requirements, parameters that specify voltage to be supplied over time, parameters associated with a desired variable voltage signal, parameters associated with a desired variable current, and/or any other number of suitable power parameters. Once the power parameters are received, the power module 246 may process the received power parameters in order to determine or identify an amount of power that should be supplied to the USB host controller 220 and/or the AMI communication board 210 via the USB connection 250. The power module 246 may then adjust the amount of power supplied via the USB connection 250. In this regard, the USB host controller 220 and/or the AMI communication board 210 may be powered by the USB device controller 215. One example of the operations of the power module 246 is described in greater detail below with reference to FIG. 3.

Powering the AMI communication board 210 via the USB connection 250 may assist in lowering the combined cost of the utility meter 205 and the AMI communication board 210. Additionally, a standard USB interface to the utility meter 205 may be provided, allowing flexibility in the types of AMI communication boards utilized with the utility meter 205 and/or permitting extension of communications capabilities. For example, a ZigBee adaptor may be added as desired. Additionally, the power supplied to the AMI communication board 210 is isolated from the power line connected to the utility meter 205.

The communications module 247 may be a suitable software module that facilitates the communication of information from the USB device controller 215 to the USB host controller 220 via the USB connection 250. Additionally, the communications module 247 may facilitate the receipt of information output by the USB host controller 220. In operation, the communications module 247 may receive measurements data and/or messages from the metrology component 225, and the communications module 247 may format the received information for output via the USB connection 250. At least a portion of the received information may be communicated to a communications module 257 associated with the USB host controller 220 via the USB connection 250. For example, information may be communicated via data conductors or data lines (e.g., lines D- and/or D+) associated with the USB connection 250. Once communicated, the information may be processed by the USB host controller 220, and at least a portion of the information may be output by the AMI communication board 210 onto an AMI network. In this regard, utility meter 205 measurements, alerts, and/or other information may be communicated to a central processor (e.g., a utility central station) via the AMI network.

With continued reference to the USB device controller 215, the one or more I/O interfaces 243 may facilitate connection of the USB device controller 215 to any number of suitable input/output devices, cables, and/or connections. For example, the I/O interfaces 243 may include a suitable interface that facilitates connection of the USB device controller 215 to a USB cable. In this regard, communications may be established between the USB device controller 215 and the USB host controller 220.

The USB connection 250 may include any suitable USB connection or USB cable. For example, the USB connection 250 may be a USB cable that includes four separate lines. Data may travel bi-directionally between the USB device controller 215 and the USB host controller 220 via two data lines. Additionally, power may be provided between the USB device controller 215 and the USB host controller 220 via a voltage or power line and a ground line. As desired, any suitable USB specification (e.g., USB 1.0, USB 2.0, USB 3.0, etc.) may be utilized in association with the USB connection 250.

With continued reference to FIG. 2, the AMI communication board 210 may be a suitable communication component or device that facilitates communications over an AMI network. In this regard, utility meter data may be communicated to a central system. Additionally, meter updates and/or other instructions may be received via the AMI network. According to an aspect of the invention, the AMI communication board 210 may include a USB host controller 220. The USB host controller 220 may be a suitable processor-driven device or processing component that is configured to facilitate communication with the USB device controller 215 associated with the utility meter 205 via a suitable USB connection. Additionally, the USB host controller 220 may be configured to receive power from the USB device controller 215. Examples of suitable processing devices that may be utilized as a USB host controller 220 include, but are not limited to, application-specific circuits, microcontrollers, minicomputers, other computing devices, and the like. The USB host controller 220 may include any number of processors 251 that facilitate the execution of computer-readable instructions to control the operations of the USB host controller 220. By executing computer-readable instructions, the USB host controller 220 may form a special purpose computer or particular machine that facilitates the receipt of power from the USB device controller 215, provision of power to the AMI communication board 210, and/or communication between the utility meter 205 and the AMI communication board 210.

In addition to one or more processors 251, the USB host controller 220 may include one or more memory devices 252 and/or one or more input/output (I/O) interfaces 253. The one or more memory devices 252 or memories may include any number of suitable memory devices, for example, caches, read-only memory devices, random access memory devices, magnetic storage devices, etc. The one or more memory devices 252 may store data, executable instructions, and/or various program modules utilized by the USB host controller 220, such as data files 254, an operating system (OS) 255, a power module 256 and/or a communications module 257. The data files 254 may include, for example, stored data associated with the operation of the USB host controller 220, stored data associated with the USB device controller 215, a USB protocol stack, and/or stored data associated with the power requirements of the USB host controller 220 and the AMI communication board 210.

The OS 255 may be a suitable software application that is executed by the one or more processors 251 to control the general operation of the USB host controller 220. Additionally, the OS 255 may facilitate the execution of additional software applications, such as the power module 256 and/or the communications module 257. The power module 256 may be a suitable software application that facilitates the receipt of power from the USB device controller 215 and/or the provision of received power to the AMI communication board 210. According to an aspect of the invention, the power may be supplied via the USB connection 250. In operation, the power module 256 may be initialized or started upon the receipt of a relatively low voltage power signal output by the USB device controller 215. Once initialized, the power module 256 (and/or the communications module 247) may perform a handshaking process to establish communications between the USB host controller 220 and the USB device controller 215. A wide variety of information may be passed between the USB device controller 215 and the USB host controller 220 during the handshaking process, such as a device identifier and/or configuration information associated with the USB device controller 215. Additionally, the power module 256 may access and/or determine one or more power parameters associated with the USB host controller 220 and/or the AMI communication board 210, such as power configuration parameters. The power module 256 may communicate the power parameters to the USB device controller 215 in order to facilitate the provision of power to the USB host controller 220 from the USB device controller 215. Following the communication of the power parameters, the USB device controller 215 may adjust an amount of power provided to the USB host controller 220, and the power module 256 may facilitate the distribution of the received power to the USB host controller 220 and the AMI communication board 210. Additionally, as desired, the power module 256 may dynamically adjust the amount of power supplied via the USB connection 250 by communicating any number of updated power parameters to the USB device controller 215.

The communications module 257 may be a suitable software module that facilitates the communication of information from the USB host controller 220 to the USB device controller 215 via the USB connection 250. Additionally, the communications module 257 may facilitate the receipt of information output by the USB device controller 215. In operation, the communications module 257 may receive a wide variety of different types of information, such as measurements data and/or messages, from the USB device controller 215. The communications module 257 may process the received information and, in certain embodiments, the communications module 257 may format at least a portion of the received information for output onto an AMI network. Additionally, the communications module 257 may receive information via the AMI network, and the communications module 257 may provide at least a portion of the received information to the utility meter 205.

With continued reference to the USB host controller 220, the one or more I/O interfaces 253 may facilitate connection of the USB host controller 220 to any number of suitable input/output devices, cables, and/or connections. For example, the I/O interfaces 253 may include a suitable interface that facilitates connection of the USB host controller 220 to a USB cable. In this regard, communications may be established between the USB device controller 215 and the USB host controller 220. Additionally, as desired, the USB host controller 220 and/or the AMI communication board 210 may include any number of suitable network interfaces that facilitate communications via an AMI network.

As desired, embodiments of the invention may include a system 200 with more or less than the components illustrated in FIG. 2. Additionally, certain components of the system 200 may be combined in various embodiments of the invention. The system 200 of FIG. 2 is provided by way of example only.

As one example of an alternative system that may be provided, a USB host controller may be incorporated into a power meter and a USB device controller may be incorporated into an AMI communications board. In such as scenario, USB control will be facilitated by the power meter rather than the AMI board. In operation, when the AMI communications board is connected to the power meter via a suitable USB connection (e.g., a USB cable), the USB host controller may recognize the USB device controller associated with the AMI communications board, and the USB host controller may initiate a handshaking process with the USB device controller. Additionally, the USB host controller may receive one or more power parameters from the USB device controller. Based at least in part upon the received power parameters, the USB host controller may direct communication of an appropriate power signal to the USB device controller and/or the AMI board.

FIG. 3 is a flow diagram of an example method 300 for powering an AMI communication board associated with a utility meter, according to an illustrative embodiment of the invention. Certain operations of the method 300 may be performed by a suitable utility meter, such as the utility meter 205 or power meter illustrated in FIG. 2. Other operations of the method 300 may be performed by a suitable AMI communication board, such as the AMI communication board 210 illustrated in FIG. 2. The method 300 may begin at block 305.

At block 305, a power meter 205 (or other utility meter) may be connected to a suitable power line. For example, a power meter 205 may be connected or coupled to an AC power line that provides power to a structure, such as a home or business. In this regard, the power meter 205 may be configured to monitor an amount of power supplied to the structure. In certain embodiments, the power meter 205 may be powered by the power line to which the meter 205 is connected.

At block 310, a USB device controller associated with the power meter, such as the USB device controller 215 illustrated in FIG. 2, may be initialized. Once initialized, at block 315, the USB device controller 215 may communicate or output a relatively low voltage power signal onto a suitable USB connection, such as a USB cable. In this regard, the relatively low voltage power signal, such as a signal of approximately 3.3 volts to approximately five (5) volts, may be communicated to a USB host controller associated with the AMI communication board 210, such as the USB host controller 220 illustrated in FIG. 2.

At block 320, the relatively low voltage power signal may be received by the USB host controller 220, and the USB host controller 220 may be powered and/or initialized based at least in part upon the receipt of the relatively low voltage power signal. Additionally, a handshaking process may be initiated between the USB host controller 220 and the USB device controller 215. In this regard, the USB device controller 215 may be configured at the USB host controller 220. At block 325, one or more power parameters, such as parameters associated with power supply requirements for the USB host controller 220 and/or the AMI communication board 210, may be communicated by the USB host controller 220 to the USB device controller 215.

At block 330, the one or more power parameters may be received by the USB device controller 215. At block 335, the USB device controller 215 may process the received one or more parameters, and the USB device controller 215 may adjust a power signal supplied to the USB host controller 220 based at least in part on the one or more power parameters. The adjusted power signal or power supply may be received by the USB host controller 220 at block 340, and the USB host controller 220 may utilize the received power to power the AMI communication board 210.

At block 345, metrology information, such as measurements data collected by a suitable metrology component associated with the power meter 205, may be communicated by the USB device controller 215 to the USB host controller 220. The metrology information may be received by the USB host controller 220 at block 350, and the AMI communication board 210 may be configured to communicate at least a portion of the metrology information onto a suitable AMI network.

The method 300 may end following block 350.

The operations described and shown in the method 300 of FIG. 3 may be carried out or performed in any suitable order as desired in various embodiments of the invention. Additionally, in certain embodiments, at least a portion of the operations may be carried out in parallel. Furthermore, in certain embodiments, less than or more than the operations described in FIG. 3 may be performed.

The invention is described above with reference to block and flow diagrams of systems, methods, apparatuses, and/or computer program products according to example embodiments of the invention. It will be understood that one or more blocks of the block diagrams and flow diagrams, and combinations of blocks in the block diagrams and flow diagrams, respectively, can be implemented by computer-executable program instructions. Likewise, some blocks of the block diagrams and flow diagrams may not necessarily need to be performed in the order presented, or may not necessarily need to be performed at all, according to some embodiments of the invention.

These computer-executable program instructions may be loaded onto a general purpose computer, a special-purpose computer, a processor, or other programmable data processing apparatus to produce a particular machine, such that the instructions that execute on the computer, processor, or other programmable data processing apparatus create means for implementing one or more functions specified in the flowchart block or blocks. These computer program instructions may also be stored in a computer-readable memory that can direct a computer or other programmable data processing apparatus to function in a particular manner, such that the instructions stored in the computer-readable memory produce an article of manufacture including instruction means that implement one or more functions specified in the flow diagram block or blocks. As an example, embodiments of the invention may provide for a computer program product, comprising a computer usable medium having a computer-readable program code or program instructions embodied therein, said computer-readable program code adapted to be executed to implement one or more functions specified in the flow diagram block or blocks. The computer program instructions may also be loaded onto a computer or other programmable data processing apparatus to cause a series of operational elements or steps to be performed on the computer or other programmable apparatus to produce a computer-implemented process such that the instructions that execute on the computer or other programmable apparatus provide elements or steps for implementing the functions specified in the flow diagram block or blocks.

Accordingly, blocks of the block diagrams and flow diagrams support combinations of means for performing the specified functions, combinations of elements or steps for performing the specified functions and program instruction means for performing the specified functions. It will also be understood that each block of the block diagrams and flow diagrams, and combinations of blocks in the block diagrams and flow diagrams, can be implemented by special-purpose, hardware-based computer systems that perform the specified functions, elements or steps, or combinations of special purpose hardware and computer instructions.

While the invention has been described in connection with what is presently considered to be the most practical and various embodiments, it is to be understood that the invention is not to be limited to the disclosed embodiments, but on the contrary, is intended to cover various modifications and equivalent arrangements included within the spirit and scope of the appended claims.

This written description uses examples to disclose the invention, including the best mode, and also to enable any person skilled in the art to practice the invention, including making and using any devices or systems and performing any incorporated methods. The patentable scope of the invention is defined in the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A power meter (205) comprising:
a metrology component (225) configured to monitor an amount of energy supplied via a power line associated with the power meter (205); and
a Universal Serial Bus (USB) controller (215) configured to (i) interface with an Advanced Metering Infrastructure (AMI) board (210) via a USB connection (250) and (ii) provide power to the AMI board (210) via the USB connection.

2. The power meter (205) of Claim 1, wherein the USB connection (250) comprises a power conductor, a ground conductor, and one or more data conductors.

3. The power meter (205) of Claim 1 or 2, wherein the USB controller (215) comprises a USB device controller (215) configured to communicate, to a USB host controller (220) associated with the AMI board (210), a low voltage power signal to facilitate power configuration of the AMI board (210), and
wherein the USB host controller (220) is initially powered by the low voltage power signal.

4. The power meter of Claim 3, wherein the low voltage power signal comprises a voltage of approximately 3.3 volts to approximately 5 volts.

5. The power meter of Claim 3 or 4, wherein the USB device controller (215) is further configured to (i) receive, from the USB host controller (220) subsequent to initial powering of the USB host controller (220), one or more power configuration parameters associated with the AMI board (210) and (ii) adjust an amount of power supplied to the USB host controller (220) based at least in part on the one or more power configuration parameters.

6. The power meter of Claim 5, wherein the metrology component (225) is further configured to provide, subsequent to the amount of power being adjusted, monitoring data to the AMI board (210) via the USB connection (250)

7. A system (200) comprising:
a power meter (205) as recited in any of claims 1 to 6, and
an Advanced Metering Infrastructure (AMI) board (210) configured to facilitate communication over an AMI network and comprising a USB host controller (220) configured to communicate with the USB device controller (215) of the power meter (205),
wherein the USB host controller (220)and the AMI board (210) are powered by the USB device controller (215) via the USB connection (250).

8. A method comprising:
providing a power meter (205) comprising (i) a meter metrology component (225) configured to monitor an amount of energy supplied via a power line and (ii) a Universal Serial Bus (USB) device controller (215) configured to interface with a USB connection (250);
connecting the power meter (205), via the USB connection (250), to an Advanced Metering Infrastructure (AMI) board (210) configured to facilitate communication over an AMI network, the AMI board (210) comprising a USB host controller (220); and
powering, by the USB device controller (215) via the USB connection (250), the USB host controller (220) and the AMI board (210).

9. The method of Claim 8, wherein connecting the power meter to an AMI board via the USB connection (250) comprises connecting the power meter (205) to an AMI board (210) via a USB connection (250) comprising a power conductor, a ground conductor, and one or more data conductors.

10. The method of Claim 8 or 9, further comprising:
communicating, by the USB device controller (215) to the USB host controller (220), a low voltage power signal to facilitate power configuration of the AMI board (210),
wherein the USB host controller (220) is initially powered by the low voltage power signal.

11. The method of any of Claims 8 to 10, wherein communicating a low voltage power signal comprises communicating a signal comprising a voltage of approximately 3.3 volts to approximately 5 volts.

12. The method of any of Claims 8 to 11, further comprising:
receiving, by the USB device controller (215) from the USB host controller (220) subsequent to the communication of the low voltage power signal, one or more power configuration parameters associated with the AMI board. (210)

13. The method of Claim 12, further comprising:
adjusting, by the USB device controller (215) based at least in part on the one or more power configuration parameters, an amount of power supplied to the USB host controller (220).

14. The method of Claim 13, further comprising:
providing, by the metrology component (225) to the AMI board (210) via the USB device controller (215) and the USB connection (250), monitoring data for communication via the AMI network.
